# EUROPEAN PATENT APPLICATION

(11) **EP 2 865 695 A1**
(43) Date of publication of application: **29.04.2015**
(21) Application number: 13806776.4
(22) Date of filing: 07.06.2013
(51) Int. Cl.: C08G 59/20, B32B 15/08, B32B 15/092, C08G 8/28, H01L 23/29, H01L 23/31, H05K 1/03

(54) **EPOXY RESIN, METHOD FOR PRODUCING SAME, EPOXY RESIN COMPOSITION, AND CURED PRODUCT**

(30) Priority: 21.06.2012 JP 2012140023
(71) Applicant: Mitsubishi Gas Chemical Company, Inc., Tokyo 100-8324 (JP)
(72) Inventor: ECHIGO, Masatoshi, Hiratsuka-shi Kanagawa 254-0016 (JP); UCHIYAMA, Naoya, Hiratsuka-shi Kanagawa 254-0016 (JP)
(74) Representative: Müller-Boré & Partner Patentanwälte PartG mbB
(86) International application number: PCT/JP2013/065806
(87) International publication number: WO 2013/191012

(57) **Abstract**

An epoxy resin obtained through the following steps (a) to (d):
(a): a step of reacting a compound represented by formula (1) and/or (2) with formaldehyde in the presence of a catalyst to thereby provide an aromatic hydrocarbon-formaldehyde resin;
(b): a step of treating the aromatic hydrocarbon-formaldehyde resin obtained in the step (a) with an acidic catalyst and water to thereby provide an acid-treated resin;
(c): a step of treating the acid-treated resin obtained in the step (b) with an acidic catalyst and a compound represented by formula (3) to thereby provide a modified resin; and
(d): a step of reacting the modified resin obtained in the step (c) with epihalohydrin to thereby provide an epoxy resin.

## Description

### Technical Field

The present invention relates to an epoxy resin, a production method thereof, an epoxy resin composition, and a cured product.

### Background Art

Conventionally, as epoxy compounds, an epi-bis-based epoxy compound of bisphenol A diglycidyl ether and a novolac-based epoxy compound of cresol novolac diglycidyl ether have been generally used.

In a composite material to be used for an aircraft member, and in a laminate, a coating material, a semiconductor sealing material and a forming material in the electronics field, a trifunctional or higher polyfunctional epoxy resin is basically used, and, in general, a novolac-based epoxy resin is often used in these applications. Representative examples of the novolac-based epoxy resin include phenol novolac-based and cresol novolac-based epoxy resins. Since the novolac -based epoxy resin is a polyfunctional resin, it can be expected to have a high crosslinking density after curing to result in increases in heat resistance and chemical resistance, but, on the contrary, it tends to be hard and brittle. In addition, the novolac-based epoxy resin is poor in moisture resistance, in particular, poor in adhesiveness with metal, and thus solder cracking due to humidity is easily caused, which is a drawback increasingly highlighted.

Patent Literature 1 discloses an epoxy resin excellent in flame retardance, which is obtained by reacting a novolac-based phenol resin obtained by reacting an aromatic hydrocarbon-formaldehyde resin with phenols including at least naphthol and other phenol compound, with epihalohydrin.

A copper-clad laminate is usually produced using, as an insulation layer, a prepreg obtained by impregnating a reinforcing substrate with a thermoset resin. In particular, a glass substrate epoxy resin copper-clad laminate is mainly used in industrial electronic equipment such as a computer and a control instrument, and in consumer electronic equipment such as a video camera and a video game. As a high density wiring circuit and high multi-layering progress, however, a conventional glass substrate epoxy resin copper-clad laminate cannot satisfy requirements in terms of heat resistance, high adhesiveness and the like, and thus a copper-clad laminate excellent in heat resistance, high adhesiveness and moisture resistance has been demanded to be developed.

### Citation List

### Patent Literature

Patent Literature 1: Japanese Patent Laid-Open No. 2009-108147

### Summary of Invention

### Technical Problem

In the above novolac-based epoxy resin, heat resistance as the drawback of a conventional epi-bis-based epoxy resin is improved, but, when being used singly or being blended with an epi-bis-based resin in a large amount, the novolac-based epoxy resin has the drawbacks of a reduction in delamination strength as well as a reduction in copper foil peel strength and a reduction in moisture resistance and the like.

In addition, the epoxy resin described in Patent Literature 1 has the following drawback: heat resistance, high adhesion property and moisture resistance are not sufficient.

An object of the present invention is to solve the drawbacks of the conventional epoxy resins, and an object thereof is to obtain an epoxy resin that is useful in applications of a composite material in the aircraft field as well as a laminate, a coating material, a semiconductor sealing material and a forming material in the electronics field, and that is excellent in heat resistance, high adhesion property and moisture resistance.

### Solution to Problem

The present inventors have made intensive studies, and as a result, have found that an epoxy resin can solve the above problems, which is obtained by reacting a compound represented by formula (1) and/or (2) with formaldehyde in the presence of a catalyst to provide a resin (hereinafter, also referred to as "aromatic hydrocarbon-formaldehyde resin".); subjecting the aromatic hydrocarbon-formaldehyde resin to a particular treatment, and thereafter a modification treatment with a compound represented by formula (3); and then reacting the resultant with epihalohydrin, thereby leading to the present invention.

That is, the present invention is as follows.
[1] An epoxy resin obtained through the following steps (a) to (d):
   (a): a step of reacting a compound represented by the following formula (1) and/or (2) with formaldehyde in the presence of a catalyst to thereby provide an aromatic hydrocarbon-formaldehyde resin;
   (b): a step of treating the aromatic hydrocarbon-formaldehyde resin obtained in the step (a) with an acidic catalyst and water to thereby provide an acid-treated resin;
   (c): a step of treating the acid-treated resin obtained in the step (b) with an acidic catalyst and a compound represented by the following formula (3) to thereby provide a modified resin; and
   (d): a step of reacting the modified resin obtained in the step (c) with epihalohydrin to thereby provide an epoxy resin. 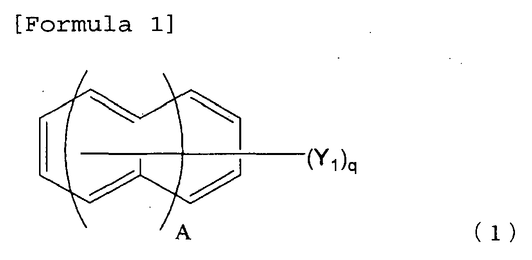 wherein Y₁ independently represents an alkyl group having 1 to 10 carbon atoms, an aryl group having 6 to 10 carbon atoms or a cyclohexyl group, q represents number of 0 to 3, and A represents number of 0 to 2. 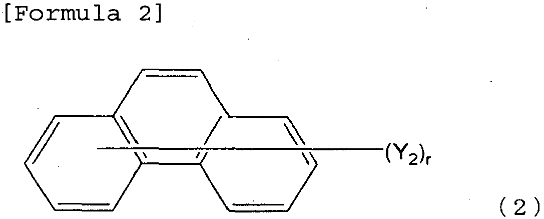 wherein Y₂ independently represents an alkyl group having 1 to 10 carbon atoms, an aryl group having 6 to 10 carbon atoms or a cyclohexyl group, and r represents number of 0 to 3. 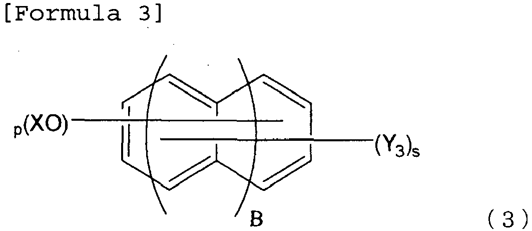 wherein X independently represents a hydrogen atom, an alkyl group having 1 to 10 carbon atoms, an aryl group having 6 to 10 carbon atoms or a cyclohexyl group, Y₃ independently represents an alkyl group having 1 to 10 carbon atoms, an aryl group having 6 to 10 carbon atoms or a cyclohexyl group, p represents number of 1 to 3, s represents number of 0 to 3, and B represents number of 0 to 3.
[2] The epoxy resin according to the above [1], wherein the compound represented by the formula (1) is at least one selected from the group consisting of benzene, toluene, xylene, mesitylene, ethylbenzene, propylbenzene, decylbenzene, cyclohexylbenzene, biphenyl, methylbiphenyl, naphthalene, methylnaphthalene, dimethylnaphthalene, ethylnaphthalene, anthracene, methylanthracene, dimethylanthracene, ethylanthracene and binaphthyl.
[3] The epoxy resin according to the above [1] or [2], wherein the compound represented by the formula (2) is at least one selected from the group consisting of phenanthrene, methylphenanthrene, dimethylphenanthrene, ethylphenanthrene, decylphenanthrene, cyclohexylphenanthrene, phenylphenanthrene and naphthylphenanthrene.
[4] The epoxy resin according to any of the above [1] to [3], wherein the compound represented by the formula (3) is at least one selected from the group consisting of phenol, methoxyphenol, benzoxyphenol, catechol, resorcinol, hydroquinone, cresol, phenylphenol, naphthol, methoxynaphthol, benzoxynaphthol, dihydroxynaphthalene, hydroxyanthracene, methoxyanthracene, benzoxyanthracene and dihydroxyanthracene.
[5] The epoxy resin according to any of the above [1] to [4], wherein, in the step (b), an amount of the acidic catalyst used is 0.0001 to 100 parts by mass based on 100 parts by mass of the aromatic hydrocarbon-formaldehyde resin, and an amount of the water used is 0.1 to 10000 parts by mass based on 100 parts by mass of the aromatic hydrocarbon-formaldehyde resin.
[6] The epoxy resin according to any of the above [1] to [5], wherein, in the step (c), an amount of the compound represented by the formula (3) used is 0.1 to 5 mol based on 1 mol of oxygen comprised in the acid-treated resin.
[7] An epoxy resin composition comprising the epoxy resin according to any of the above [1] to [6].
[8] A cured product obtained by curing the epoxy resin composition according to the above [7].
[9] A copper-clad laminate comprising the epoxy resin according to any of the above [1] to [6].
[10] A resin composition for a semiconductor sealing, comprising the epoxy resin according to any of the above [1] to [6].
[11] A method for producing an epoxy resin, comprising the following steps (a) to (d):
   (a): a step of reacting a compound represented by the following formula (1) and/or (2) with formaldehyde in the presence of a catalyst to thereby provide an aromatic hydrocarbon-formaldehyde resin;
   (b): a step of treating the aromatic hydrocarbon-formaldehyde resin obtained in the step (a) with an acidic catalyst and water to thereby provide an acid-treated resin;
   (c): a step of treating the acid-treated resin obtained in the step (b) with an acidic catalyst and a compound represented by the following formula (3) to thereby provide a modified resin; and
   (d): a step of reacting the modified resin obtained in the step (c) with epihalohydrin to thereby provide an epoxy resin. 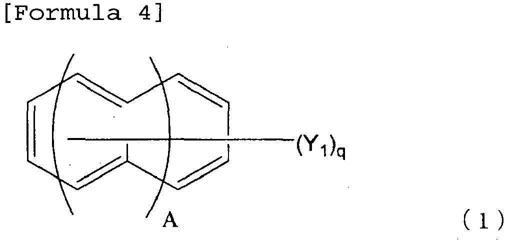 wherein Y₁ independently represents an alkyl group having 1 to 10 carbon atoms, an aryl group having 6 to 10 carbon atoms or a cyclohexyl group, q represents number of 0 to 3, and A represents number of 0 to 2. 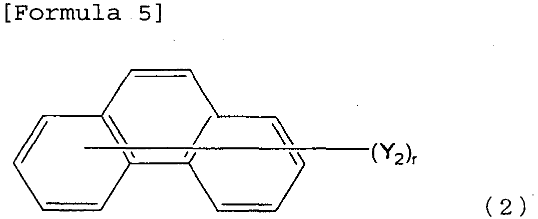 wherein Y₂ independently represents an alkyl group having 1 to 10 carbon atoms, an aryl group having 6 to 10 carbon atoms or a cyclohexyl group, and r represents number of 0 to 3. 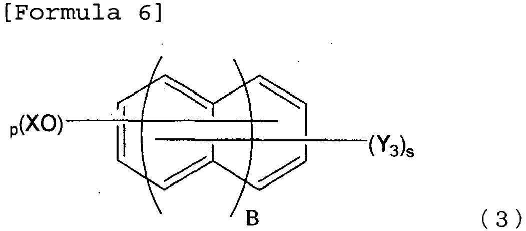 wherein X independently represents a hydrogen atom, an alkyl group having 1 to 10 carbon atoms, an aryl group having 6 to 10 carbon atoms or a cyclohexyl group, Y₃ independently represents an alkyl group having 1 to 10 carbon atoms, an aryl group having 6 to 10 carbon atoms or a cyclohexyl group, p represents number of 1 to 3, s represents number of 0 to 3, and B represents number of 0 to 3.

### Advantageous Effects of Invention

The epoxy resin of the present invention is excellent in heat resistance, high in adhesion property and also excellent in moisture resistance, and therefore is useful as a resin for a laminate, semiconductor sealing, a forming material, an adhesive, coating, and the like.

### Description of Embodiments

Hereinafter, an embodiment for carrying out the present invention (hereinafter, also referred to as "present embodiment".) is described in detail. Herein, the present invention is not limited to the following embodiment, and can be carried out with a various modification within the gist thereof.

An epoxy resin in the present embodiment is an epoxy resin obtained through the following steps (a) to (d):
(a): a step of reacting the compound represented by the formula (1) and/or (2) with formaldehyde in the presence of a catalyst to thereby provide an aromatic hydrocarbon-formaldehyde resin;
(b): a step of treating the aromatic hydrocarbon-formaldehyde resin obtained in the step (a) with an acidic catalyst and water to thereby provide an acid-treated resin;
(c): a step of treating the acid-treated resin obtained in the step (b) with an acidic catalyst and the compound represented by the formula (3) to thereby provide a modified resin; and
(d): a step of reacting the modified resin obtained in the step (c) with epihalohydrin to thereby provide an epoxy resin.

### [Step (a)]

Step (a) is a step of reacting the compound represented by the formula (1) and/or (2) with formaldehyde in the presence of a catalyst to thereby provide an aromatic hydrocarbon-formaldehyde resin.

### [Aromatic hydrocarbon-formaldehyde resin]

The method for producing the aromatic hydrocarbon-formaldehyde resin for use in the present embodiment is not particularly limited, and the aromatic hydrocarbon-formaldehyde resin can be obtained from the compound represented by the following formula (1) and/or (2) by application of a known method.

For example, the aromatic hydrocarbon-formaldehyde resin can be obtained by a condensation reaction of the compound represented by the following formula (1) and/or (2) with formaldehyde in the presence of a catalyst, according to the method described in Japanese Patent Publication No. 37-5747. The aromatic hydrocarbon-formaldehyde resin obtained by such a method can be identified by gel permeation chromatography, organic elemental analysis, measurements of the softening point and the hydroxyl value, and the like. 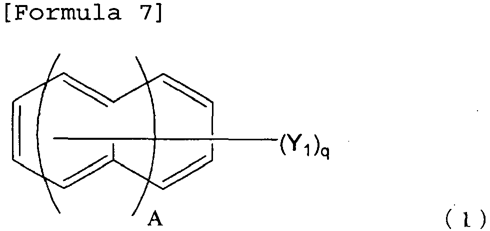 wherein Y₁ independently represents an alkyl group having 1 to 10 carbon atoms, an aryl group having 6 to 10 carbon atoms or a cyclohexyl group, q represents number of 0 to 3, and A represents number of 0 to 2. 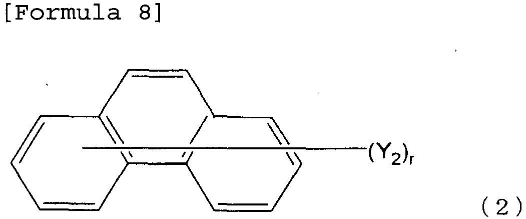 wherein Y₂ independently represents an alkyl group having 1 to 10 carbon atoms, an aryl group having 6 to 10 carbon atoms or a cyclohexyl group, and r represents number of 0 to 3.

The compounds represented by the formula (1) include benzene, toluene, xylene, mesitylene, ethylbenzene, propylbenzene, decylbenzene, cyclohexylbenzene, biphenyl, methylbiphenyl, naphthalene, methylnaphthalene, dimethylnaphthalene, ethylnaphthalene, anthracene, methylanthracene, dimethylanthracene, ethylanthracene and binaphthyl. Biphenyl, naphthalene, methylnaphthalene, dimethylnaphthalene, anthracene, methylanthracene and dimethylanthracene are preferable from the viewpoint of simultaneously satisfying heat resistance and solubility in a well-balanced manner, and biphenyl, naphthalene, methylnaphthalene and dimethylnaphthalene are more preferable from the viewpoint of industrial application.

The compounds represented by the formula (2) include phenanthrene, methylphenanthrene, dimethylphenanthrene, ethylphenanthrene, decylphenanthrene, cyclohexylphenanthrene, phenylphenanthrene and naphthylphenanthrene. Phenanthrene, cyclohexylphenanthrene and phenylphenanthrene are preferable and phenanthrene is more preferable from the viewpoint of simultaneously satisfying heat resistance and solubility in a well-balanced manner.

### [Step (b)]

Step (b) is a step of treating the aromatic hydrocarbon-formaldehyde resin obtained in step (a) with an acidic catalyst and water to thereby provide an acid-treated resin.

### [Acid-treated resin (deacetalized aromatic hydrocarbon-formaldehyde resin)]

The acid-treated resin for use in the present embodiment can be obtained by treating the aromatic hydrocarbon-formaldehyde resin with an acidic catalyst and water. The acid-treated resin has naphthalene rings crosslinked by -(CH₂)₁- and/or CH₂A-, wherein A, l, and m represent -(OCH₂)ₘ-, number of 1 to 10, and number of 0 to 10, respectively. The acidic catalyst and water are used for the treatment to thereby reduce the number of direct bonds between oxymethylenes and the like via no naphthalene ring, resulting in the reduction in number l and/or m. That is, the number of acetal bonds at a position via a naphthalene ring is reduced.

Herein, the acid-treated resin is also referred to as "deacetalized aromatic hydrocarbon-formaldehyde resin". The deacetalized aromatic hydrocarbon-formaldehyde resin has a further enhanced thermal decomposition resistance as compared with a resin not subjected to the above acid treatment.

In the treatment with an acidic catalyst and water, the acidic catalyst can be appropriately selected from known inorganic acids and organic acids. Examples thereof include inorganic acids such as hydrochloric acid, sulfuric acid, phosphoric acid, hydrobromic acid and hydrofluoric acid; organic acids such as oxalic acid, malonic acid, succinic acid, adipic acid, sebacic acid, citric acid, fumaric acid, maleic acid, formic acid, p-toluenesulfonic acid, methanesulfonic acid, trifluoroacetic acid, dichloroacetic acid, trichloroacetic acid, trifluoromethanesulfonic acid, benzenesulfonic acid, naphthalenesulfonic acid and naphthalenedisulfonic acid; Lewis acids such as zinc chloride, aluminum chloride, iron chloride and boron trifluoride; and solid acids such as tungstosilicic acid, phosphotungstic acid, silicomolybdic acid and phosphomolybdic acid. Among them, sulfuric acid, oxalic acid, citric acid, p-toluenesulfonic acid, methanesulfonic acid, trifluoromethanesulfonic acid, benzenesulfonic acid, naphthalenesulfonic acid, naphthalenedisulfonic acid and phosphotungstic acid are preferable in terms of production.

The treatment with the acidic catalyst and water is usually performed in the presence of the acidic catalyst at ordinary pressure, and performed at a temperature where raw materials used are compatible, or higher (usually 80 to 300°C) while water to be used being dropped or sprayed as steam to the system. Water in the system may be distilled off or refluxed, but is preferably distilled off together with a low boiling component generated in the reaction, such as formaldehyde, because an acetal bond can be effectively removed. The pressure may be ordinary pressure or increased pressure. If necessary, an inert gas such as nitrogen, helium or argon may also be allowed to pass through the system.

If necessary, an inert solvent in the reaction can also be used. Examples of the solvent include aromatic hydrocarbons such as toluene, ethylbenzene and xylene; saturated aliphatic hydrocarbons such as heptane and hexane; alicyclic hydrocarbons such as cyclohexane; ethers such as dioxane and dibutyl ether; alcohols such as 2-propanol; ketones such as methyl isobutyl ketone; carboxylic acid esters such as ethyl propionate; and carboxylic acids such as acetic acid.

The amount of the acidic catalyst used is preferably 0.0001 to 100 parts by mass, more preferably 0.001 to 85 parts by mass and further preferably 0.001 to 70 parts by mass, based on 100 parts by mass of the aromatic hydrocarbon-formaldehyde resin. When the amount of the acidic catalyst used falls within the above range, a proper reaction speed tends to be achieved, and the increase in resin viscosity due to a high reaction speed tends to be able to be prevented. The acidic catalyst may be collectively added or may be added in portions.

Water that can be used in the treatment is not particularly limited as long as it can be industrially used, and includes tap water, distilled water, ionexchange water, pure water or ultrapure water.

The amount of water used is preferably 0.1 to 10000 parts by mass, more preferably 1 to 5000 parts by mass and further preferably 10 to 3000 parts by mass, based on 100 parts by mass of the aromatic hydrocarbon-formaldehyde resin. When the amount of water used falls within the above range, a proper reaction speed tends to be achieved, and thereby the intended resin tends to be effectively obtained.

The treatment time is preferably 0.5 to 20 hours, more preferably 1 to 15 hours and further preferably 2 to 10 hours. When the treatment time falls within the above range, a resin having the intended properties tends to be able to be obtained economically and industrially.

The treatment temperature is preferably 80 to 300°C, more preferably 85 to 270°C and further preferably 90 to 240°C. When the treatment temperature falls within the above range, a resin having the intended properties tends to be able to be obtained economically and industrially.

After the completion of the treatment, the solvent is, if necessary, further added for dilution, followed by washing with water, thereby completely removing the acidic catalyst. The resultant is left to still stand to thereby separate two phases, and a resin phase as an oil phase and an aqueous phase are separated from each other. The solvent added and the like are then removed from the resin phase by a common method such as distillation to thereby provide a deacetalized aromatic hydrocarbon-formaldehyde resin (acid-treated resin).

The deacetalized aromatic hydrocarbon-formaldehyde resin has a lower oxygen concentration and a higher softening point than the aromatic hydrocarbon-formaldehyde resin. For example, when the treatment is performed under conditions of an amount of the acidic catalyst used of 0.05 parts by mass based on 100 parts by mass of the aromatic hydrocarbon-formaldehyde resin, an amount of water used of 2000 parts by mass based on 100 parts by mass of the aromatic hydrocarbon-formaldehyde resin, a treatment time of 5 hours and a treatment temperature of 150°C, the oxygen concentration is lowered by about 0.1 to 8.0% by mass, and the softening point is increased by about 3 to 100°C.

### [Step (c)]

Step (c) is a step of treating the acid-treated resin obtained in step (b) with an acidic catalyst and the compound represented by the following formula (3) to thereby provide a modified resin.

### [Modified resin (modified deacetalized aromatic hydrocarbon-formaldehyde resin)]

The modified resin for use in the present embodiment is obtained by heating the deacetalized aromatic hydrocarbon-formaldehyde resin (acid-treated resin) and the compound represented by the formula (3) in the presence of an acidic catalyst for modification. Herein, the modified resin is also referred to as "modified deacetalized aromatic hydrocarbon-formaldehyde resin". 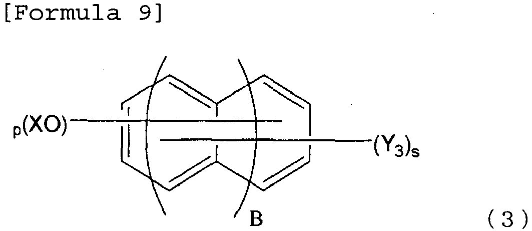 wherein X independently represents a hydrogen atom, an alkyl group having 1 to 10 carbon atoms, an aryl group having 6 to 10 carbon atoms or a cyclohexyl group, Y₃ independently represents an alkyl group having 1 to 10 carbon atoms, an aryl group having 6 to 10 carbon atoms or a cyclohexyl group, p represents number of 1 to 3, s represents number of 0 to 3, and B represents number of 0 to 3.

In the compound represented by the formula (3) for use in the modification, X preferably represents a hydrogen atom, an alkyl group having 1 to 4 carbon atoms, an aryl group having 6 to 10 carbon atoms or a cyclohexyl group, Y₃ preferably represents an alkyl group having 1 to 4 carbon atoms, an aryl group having 6 to 10 carbon atoms or a cyclohexyl group, in terms of production. In addition, p preferably represents 1 to 2, and s preferably represents 0 to 2.

Examples of the compound represented by the formula (3) can include phenol, methoxyphenol, benzoxyphenol, catechol, resorcinol, hydroquinone, cresol, phenylphenol, naphthol, methoxynaphthol, benzoxynaphthol, dihydroxynaphthalene, hydroxyanthracene, methoxyanthracene, benzoxyanthracene and dihydroxyanthracene.

Among them, a phenol derivative including a conjugate structure that involves unshared electron pairs of at least two benzene rings is preferable because of being excellent in thermal decomposition resistance, and phenylphenol, naphthol, methoxynaphthol, benzoxynaphthol, dihydroxynaphthalene, hydroxyanthracene, methoxyanthracene, benzoxyanthracene and dihydroxyanthracene are more preferable.

In addition, among them, a compound having a hydroxy group is preferable because of being excellent in crosslinkability with an acid crosslinking agent, and phenylphenol, naphthol, dihydroxynaphthalene, hydroxyanthracene and dihydroxyanthracene are more preferable.

The amount of the compound represented by the formula (3) used is preferably 0.1 to 5 mol, more preferably 0.2 to 4 mol and further preferably 0.3 to 3 mol, based on 1 mol of oxygen comprised in the deacetalized aromatic hydrocarbon-formaldehyde resin (acid-treated resin). When the amount of the compound represented by the formula (3) used falls within the above range, the yield of the resulting modified deacetalized aromatic hydrocarbon formaldehyde can be kept relatively high, and the amount of the remaining unreacted compound represented by the formula (3) tends to be able to be reduced.

The modification treatment is usually performed in the presence of the acidic catalyst at ordinary pressure, and performed at a temperature where raw materials used are compatible, or higher (usually 80 to 300°C) with heating under reflux or with water generated being distilled off. The pressure may be ordinary pressure or increased pressure. If necessary, an inert gas such as nitrogen, helium or argon may also be allowed to pass through the system.

If necessary, an inert solvent in the condensation reaction can also be used. Examples of the solvent include aromatic hydrocarbons such as toluene, ethylbenzene and xylene; saturated aliphatic hydrocarbons such as heptane and hexane; alicyclic hydrocarbons such as cyclohexane; ethers such as dioxane and dibutyl ether; alcohols such as 2-propanol; ketones such as methyl isobutyl ketone; carboxylic acid esters such as ethyl propionate; and carboxylic acids such as acetic acid.

The acidic catalyst that can be used for the modification treatment can be appropriately selected from known inorganic acids and organic acids. Examples include inorganic acids such as hydrochloric acid, sulfuric acid, phosphoric acid, hydrobromic acid and hydrofluoric acid; organic acids such as oxalic acid, malonic acid, succinic acid, adipic acid, sebacic acid, citric acid, fumaric acid, maleic acid, formic acid, p-toluenesulfonic acid, methanesulfonic acid, trifluoroacetic acid, dichloroacetic acid, trichloroacetic acid, trifluoromethanesulfonic acid, benzenesulfonic acid, naphthalenesulfonic acid and naphthalenedisulfonic acid; Lewis acids such as zinc chloride, aluminum chloride, iron chloride and boron trifluoride; and solid acids such as tungstosilicic acid, phosphotungstic acid, silicomolybdic acid and phosphomolybdic acid. Among them, sulfuric acid, oxalic acid, citric acid, p-toluenesulfonic acid, methanesulfonic acid, trifluoromethanesulfonic acid, benzenesulfonic acid, naphthalenesulfonic acid, naphthalenedisulfonic acid and phosphotungstic acid are preferable in terms of production.

The amount of the acidic catalyst used is preferably 0.0001 to 100 parts by mass, more preferably 0.001 to 85 parts by mass and further preferably 0.001 to 70 parts by mass, based on 100 parts by mass of the deacetalized aromatic hydrocarbon-formaldehyde resin (acid-treated resin). When the amount of the acidic catalyst used falls within the above range, a proper reaction speed tends to be achieved, and the increase in resin viscosity due to a high reaction speed tends to be able to be prevented. The acidic catalyst may be collectively added or may be added in portions.

The reaction time is preferably 0.5 to 20 hours, more preferably 1 to 15 hours, and further preferably 2 to 10 hours. When the reaction time falls within the above range, a resin having the intended properties tends to be able to be obtained economically and industrially.

The reaction temperature is preferably 80 to 300°C, more preferably 85 to 270°C and further preferably 90 to 240°C. When the reaction temperature falls within the above range, a resin having the intended properties tends to be able to be obtained economically and industrially.

After the completion of the reaction, the solvent is, if necessary, further added for dilution, followed by washing with water, thereby completely removing the acidic catalyst. The resultant is left to still stand to thereby separate two phases, and a resin phase as an oil phase and an aqueous phase are separated from each other. The solvent added and/or the unreacted raw materials are then removed from the resin phase by a common method such as distillation to thereby provide a modified deacetalized aromatic hydrocarbon-formaldehyde resin.

The modified deacetalized aromatic hydrocarbon-formaldehyde resin has an enhanced thermal decomposition resistance as compared with a modified aromatic hydrocarbon-formaldehyde resin obtained by directly modifying the aromatic hydrocarbon-formaldehyde resin with no acid treatment.

The modified deacetalized aromatic hydrocarbon-formaldehyde resin has increased thermal decomposition resistance and hydroxyl value as compared with the deacetalized aromatic hydrocarbon-formaldehyde resin. For example, when the modification is performed under conditions of an amount of the acidic catalyst used of 0.05 parts by mass based on 100 parts by mass of the deacetalized aromatic hydrocarbon-formaldehyde resin, a reaction time of 5 hours and a reaction temperature of 200°C, the thermal decomposition resistance is increased by about 1 to 50%, and the hydroxyl value [mgKOH/g] is increased by about 1 to 300.

### [Step (d)]

Step (d) is a step of reacting the modified resin obtained in step (c) with epihalohydrin to thereby provide an epoxy resin.

### [Epoxy resin]

An epoxy resin in the present embodiment is obtained by reacting the modified deacetalized aromatic hydrocarbon-formaldehyde resin with epihalohydrin, and obtained by reacting the phenolic hydroxyl group of the modified deacetalized aromatic hydrocarbon-formaldehyde resin with epihalohydrin by a known method, for epoxidation. Specifically, for example, the reaction can be made according to the method described in Japanese Patent Laid-Open No. 2009-108147.

### [Epoxy resin composition]

An epoxy resin composition in the present embodiment comprises the epoxy resin in the present embodiment. The epoxy resin composition may comprise an epoxy resin other than the epoxy resin in the present embodiment. As such an epoxy resin, known one for use in a laminate, a sealing resin, an adhesive, a paint, and the like can be used, and conventional one generally used can be used without particular limitation as long as the effect of the present invention is not impaired.

The epoxy resin that can be mixed with the epoxy resin in the present embodiment and used is not particularly limited, and examples thereof include a novolac-based epoxy resin, a bisphenol A-based epoxy resin, a biphenyl-based epoxy resin, a triphenylmethane-based epoxy resin and a phenol aralkyl-based epoxy resin. Specifically, examples thereof include polycondensates of bisphenol A, bisphenol S, thiodiphenol, fluorene bisphenol, terpene diphenol, 4,4'-biphenol, 2,2'-biphenol, 3,3',5,5'-tetramethyl-[1,1'-biphenyl]-4,4'-diol, hydroquinone, resorcin, naphthalenediol, tris-(4-hydroxyphenyl)methane, 1,1,2,2-tetrakis(4-hydroxyphenyl)ethane, and phenols (phenol, alkyl substituted phenol, naphthol, alkyl substituted naphthol, dihydroxybenzene, dihydroxynaphthalene, and the like) with formaldehyde, acetaldehyde, benzaldehyde, p-hydroxybenzaldehyde, o-hydroxybenzaldehyde, p-hydroxyacetophenone, o-hydroxyacetophenone, dicyclopentadiene, furfural, 4,4'-bis(chloromethyl)-1,1'-biphenyl, 4,4'-bis(methoxymethyl)-1,1'-biphenyl, 1,4-bis(chloromethyl)benzene, and 1,4-bis(methoxymethyl)benzene, and modified products thereof; glycidyl etherified products derived from halogenated bisphenols such as tetrabromobisphenol A, and alcohols; and solid or liquid epoxy resins such as an alicyclic epoxy resin, a glycidyl amine-based epoxy resin and a glycidyl ester-based epoxy resin, but not limited thereto. These epoxy resins may be used singly or in combination of two or more.

The proportion of the epoxy resin in the present embodiment in the entire epoxy resin is preferably 30% by mass or more and more preferably 40% by mass or more. When the epoxy resin in the present embodiment is used as a modifier in the epoxy resin composition, however, it is preferably added in a proportion of 1 to 30% by mass.

A curing accelerator, a catalyst, a curing agent, and the like can be blended in the epoxy resin composition in the present embodiment.

As the curing accelerator and the catalyst, those generally used for an epoxy resin, such as imidazoles or imidazolines, or amines may be used. Representative examples thereof include 2-ethyl-4-methylimidazole and 2,4,6-tris(diaminomethyl)phenol (abbreviation: DMP-30).

The amounts of the curing accelerator and the catalyst blended can be set as long as the effect of the present invention is not impaired, but are each usually in a range of 0.1 to 5.0 parts by mass based on 100 parts by mass of the epoxy resin, if necessary.

As the curing agent, various known curing agents can be used depending on applications of the epoxy resin composition. Examples of a curing agent for sealing include a novolac-based phenol resin. Examples of a curing agent for a laminate include dicyandiamide, and the curing agent may be used in combination with the catalyst. Examples of a curing agent for casting or filament winding include acid anhydride such as phthalic anhydride. Examples of a curing agent for an adhesive or an anticorrosion paint include curing agents for curing at low temperatures, such as aromatic amines including metaxylenediamine, an aliphatic amine, and a polyamine.

The amount of the curing agent blended can be set arbitrarily as long as the effect of the present invention is not impaired, but is usually in a range from 0.7 to 1.2 equivalents based on 1 equivalent of an epoxy group in the epoxy resin. When the amount is less than 0.7 equivalents or more than 1.2 equivalents based on 1 equivalent of an epoxy group, curing may be incompletely made not to achieve good physical properties of cured products in each case.

When the epoxy resin composition in the present embodiment is used to produce laminates, the laminates are produced by coating or impregnating a predetermined substrate with the epoxy resin composition, drying the resultant to produce a B-stage prepreg, appropriately stacking a plurality of the prepregs, appropriately stacking a copper foil thereon, and pressurizing and heating. In this case, as a reinforcing substrate, a glass fiber cloth is commonly used. Furthermore, an aromatic polyamide fiber, an aromatic polyester fiber, an aromatic polyester imide fiber, or the like can be used, and mat glass, polyester, aromatic polyamide, an aromatic polyester fiber, an aromatic polyester imide fiber, or the like can also be used.

The amount of the reinforcing substrate can be set arbitrarily as long as the effect of the present invention is not impaired, but is usually in a range of 0.05 to 50 parts by mass based on 100 parts by mass of the epoxy resin composition, and preferably used in a range from 0.05 to 20 parts by mass from the viewpoints of the flame retardance and heat resistance of a cured product.

The reinforcing substrate is coated or impregnated under usual conditions, for example, at about room temperature to about 60°C, and dried at 100°C to 180°C for 3 minutes to 20 minutes to produce a B-stage prepreg. Heating and pressurizing are usually performed under conditions appropriately selected within ranges of a temperature of 120°C to 230°C, a pressure of 5 kg/cm² to 150 kg/cm² and a time of 30 minutes to 240 minutes.

When the epoxy resin composition in the present embodiment is used as a resin for sealing, additives, for example, an inorganic filler such as silica, a release agent such as carnauba wax, a coupling agent such as epoxysilane, and a flame retardant such as antimony trioxide and a halogen compound are usually selected depending on the intended use and added to the epoxy resin composition, and the resulting composition is heated and kneaded using a twin-screw kneader, a hot roll, a Henschel mixer, or the like. Furthermore, the resulting molding powder is appropriately formed into a tablet, and subjected to compression or transfer molding using a mold, in which primarily cure is carried out at 20 kg/cm² to 100 kg/cm² and 150°C to 200°C and thereafter post-cured is carried out at 180°C to 230°C for about 2 hours to 12 hours.

The additives may be used singly or in combination of two or more. The amount of the additives used can be set arbitrarily as long as the effect of the present invention is not impaired, but the additives is usually used in a range from 0 to 95% by mass in the epoxy resin composition, and preferably used in a range of 50% by mass or more and more preferably in a range of 70% by mass or more from the viewpoints of flame retardance and mechanical strength.

Since the epoxy resin composition in the present embodiment is excellent in heat resistance, high adhesion property and moisture resistance, has plasticity, stress relaxation property and the like in heating, and furthermore is excellent in electric performance, in particular, high frequency characteristic etc., it can be suitably used as a resin composition for adhesion or heat resistant coating, in addition to the above.

### Examples

Hereinafter, the present invention will be described by Examples in more detail, but the present invention is not limited by these Examples at all.

### <Molecular weights>

The mass average molecular weight (Mw) and the number average molecular weight (Mn) in terms of polystyrene were determined by gel permeation chromatography (GPC) analysis, and the dispersivity (Mw/Mn) was determined therefrom.
Apparatus: Shodex GPC-101 Model (manufactured by Showa Denko K. K.)
Column: LF-804 x 3
Eluent: THF 1 ml/min
Temperature: 40°C

### <Carbon and oxygen concentrations in resin>

The carbon and the oxygen concentrations (% by mass) in a resin were measured by organic elemental analysis. In addition, the molar number of oxygen comprised in 1 g of a resin was calculated according to the following expression.
Apparatus: CHN Corder MT-6 (manufactured by Yanaco Bunseki Kogyo Co.)
Expression: molar number of oxygen comprised in 1 g of resin (mol/g) = oxygen concentration (% by mass)/16

### <Softening point>

The softening point of a resin was measured according to JIS-K5601.

### <Hydroxyl value>

The hydroxyl value of a resin was measured according to JIS-K1557.

### <Melting point>

The melting point of a resin was measured according to JIS-K0064.

### [Example 1]

### (Preparation of naphthalene formaldehyde resin)

A bottom-removable four-necked flask having an inner volume of 1 L and equipped with a Dimroth condenser, a thermometer and a stirring blade was charged with 64.1 g of naphthalene (0.5 mol, produced by Kanto Chemical Co., Inc.), 150 g of 40% by mass formalin aqueous solution (2 mol as formaldehyde, produced by Mitsubishi Gas Chemical Company, Inc.) and 79.7 g of 98% by mass sulfuric acid (produced by Kanto Chemical Co., Inc.) in a nitrogen stream, and the content of the flask was reacted with stirring under reflux under ordinary pressure at 100°C for 6 hours. Thereto was added 150 g of ethylbenzene (produced by Kanto Chemical Co., Inc.) as a dilution solvent, and the resultant was left to still stand, followed by removing an aqueous phase as a lower phase. Furthermore, the resultant was subjected to neutralization and washing with water, and ethylbenzene and unreacted naphthalene were then distilled off under reduced pressure to thereby provide 69.7 g of a naphthalene formaldehyde resin as a light yellow solid.

As the results of GPC measurement, the Mn was 459, the Mw was 882, and the Mw/Mn was 1.92. As the results of organic elemental analysis, the carbon concentration was 86.4% by mass, and the oxygen concentration was 8.0% by mass (the molar number of oxygen comprised in 1 g of the resin was 0.0050 mol/g). The softening point was 84°C and the hydroxyl value was 25 mgKOH/g.

### (Preparation of acid-treated resin)

A four-necked flask having an inner volume of 0.5 L and equipped with a Dean-Stark tube having a Dimroth condenser disposed thereto, a thermometer and a stirring blade was charged with 50.0 g of the naphthalene formaldehyde resin, 50 g of ethylbenzene (produced by Kanto Chemical Co., Inc.) and 50 g of methyl isobutyl ketone (produced by Kanto Chemical Co., Inc.) for dissolving at 120°C, and 2.5 mg of paratoluenesulfonic acid (produced by Wako Pure Chemical Industries, Ltd.) was then added thereto under a steam stream with stirring, to start the reaction. After 2 hours, 1.3 mg of paratoluenesulfonic acid (produced by Wako Pure Chemical Industries, Ltd.) was further added thereto for the reaction for further 3 hours (5 hours in total). After dilution with 150 g of ethylbenzene (produced by Kanto Chemical Co., Inc.), the resultant was subjected to neutralization and washing with water, and the solvent was removed under reduced pressure to thereby provide 40.9 g of an acid-treated resin (deacetalized naphthalene formaldehyde resin) as a light red solid.

As the results of GPC measurement, the Mn was 290, the Mw was 764, and the Mw/Mn was 2.63. As the results of organic elemental analysis, the carbon concentration was 87.9% by mass, and the oxygen concentration was 5.9% by mass (the molar number of oxygen comprised in 1 g of the resin was 0.0037 mol/g). The softening point was 107°C and the hydroxyl value was 32 mgKOH/g.

### (Preparation of modified resin)

A four-necked flask having an inner volume of 0.3 L and equipped with a Liebig condenser, a thermometer and a stirring blade was charged with 40.5 g of the acid-treated resin (the molar number of oxygen comprised was 0.15 mol) and 43.3 g of 1-naphthol (0.30 mol, produced by Tokyo Chemical Industry, Co., Ltd.) under a nitrogen stream for heating and melting at 120°C, and 2.3 mg of paratoluenesulfonic acid (produced by Wako Pure Chemical Industries, Ltd.) was then added with stirring, to start the reaction. After the resultant was immediately heated to 190°C and retained with stirring for 3 hours, 1.5 mg of paratoluenesulfonic acid (produced by Wako Pure Chemical Industries, Ltd.) was added, and the resultant was further heated to 220°C for the reaction for 2 hours (5 hours in total). After dilution with 180 g of a mixed solvent (metaxylene (produced by Mitsubishi Gas Chemical Company, Inc.)/methyl isobutyl ketone (produced by Kanto Chemical Co., Inc.) = 1/1 (mass ratio)), the resultant was subjected to neutralization and washing with water, and the solvent was removed under reduced pressure to thereby provide 48.1 g of a modified resin (modified deacetalized naphthalene formaldehyde resin) as a blackish brown solid.

As the results of GPC analysis, the Mn was 493, the Mw was 750, and the Mw/Mn was 1.52. As the results of organic elemental analysis, the carbon concentration was 89.9% by mass, and the oxygen concentration was 4.9% by mass. The hydroxyl value was 192 mgKOH/g.

### (Preparation of epoxy resin)

A four-necked flask having an inner volume of 0.3 L and equipped with a Liebig condenser, a thermometer and a stirring blade was charged with 40.0 g of the modified resin and 6.4 g of sodium hydroxide, which were dissolved in 60.0 g of water, the content of the flask was heated to 50°C under a nitrogen stream with strongly stirring, and thereafter 15.0 g of epichlorohydrin was stirred and mixed therewith for the reaction for 6 hours with the temperature being kept at 80°C. After the completion of the reaction, the unreacted epichlorohydrin was removed under reduced pressure, xylene was then added thereto, and the resultant was stirred and left to still stand to remove water. An operation in which pure water was again added for washing and water was removed was repeated for purification. Then, xylene was removed by distillation under reduced pressure to thereby provide 40.1 g of an epoxy resin as a blackish brown solid.

As the results of GPC analysis, the Mn was 720, the Mw was 1100, and the Mw/Mn was 1.53. In addition, the melting point of the resin was 124°C.

### [Comparative Example 1]

The same manner as in Example 1 was performed except that the acid treatment was not performed, to thereby provide 40.1 g of an epoxy resin as a blackish brown solid.

As the results of GPC analysis, the Mn was 700, the Mw was 980, and the Mw/Mn was 1.96. In addition, the melting point of the resin was 114°C.

### [Comparative Example 2]

An acid-treated resin was prepared in the same manner as in Example 1. The resulting acid-treated resin was used, and stirred and mixed with epichlorohydrin with no modification treatment, but the reaction did not progress.

### [Example 2]

### (Preparation of copper-clad laminate)

With 70 parts of a brominated epoxy compound (produced by Tohto Kasei Co., Ltd., product number: FX132, epoxy equivalent: 485 WPE) was blended 30 parts of the epoxy resin obtained in Example 1, and 3.1 parts of dicyandiamide (abbreviation: DICY) as a curing agent, 0.08 parts of 2-ethyl-4-methylimidazole (abbreviation: 2E4MZ) as a catalyst, and 32 parts of methyl ethyl ketone and 8 parts of dimethylformamide as solvents were added thereto to prepare an epoxy resin composition.

A glass cloth (#7628-SV657, 0.2 mm in thickness) was impregnated with the resin composition, and the resultant was dried in a drier at 150°C for 15 minutes to provide a prepreg. Four of the prepregs were stacked, copper foils of 18 µm and 35 µm, whose both surfaces were roughened, were stacked on both surfaces of the resultant, and lamination molding was performed at a pressure of 80 kg/cm² and a temperature of 170°C for 90 minutes to provide a both-surface copper-clad laminate having a thickness of 0.8 mm. The resulting both-surface copper-clad laminate was tested according to JIS S C-6481 and K-6911, and as a result, it was confirmed to have a high heat resistance, a low water absorption property, solder cracking resistance, and a high adhesion property.

### [Example 3]

### (Production of resin composition for semiconductor sealing)

With 20 parts of a brominated phenol novolac-based epoxy resin (produced by Nippon Kayaku Co., Ltd., product name; BREN, epoxy equivalent: 285) was blended 60 parts of the epoxy resin obtained in Example 1, furthermore 41 parts of bisphenol A novolac (produced by DIC Corporation, product name; LF7911) as a curing agent, 1 part of 2,4,6-tris(diaminomethyl)phenol (abbreviation: DMP-30) as a curing accelerator, and 2 parts of carnauba wax as a release agent were blended therewith, and a binder was ground and mixed. In addition, 1 part of γ-glycidoxypropyltrimethoxysilane (produced by NUC Corporation, product name; A-187) as a coupling agent, 1 part of carbon black as a colorant, 5 parts of an antimony trioxide powder as a flame retardant aid, and a filler made of 350 parts of a synthetic silica powder, as a filling material, were mixed by a Henschel mixer. The binder and the filler produced above were used, roll-kneaded at 70 to 80°C for 10 minutes and roughly ground, and then formed into a tablet to provide a resin composition for semiconductor sealing.

The resulting resin composition was subjected to transfer molding in a mold, in which the upper mold was provided with an aluminum foil, under conditions of 180°C, 2 minutes and 70 kg/cm² to thereby provide a cured resin test piece. The resulting test piece was tested for the workability in molding, the heat resistance, the moisture resistance, and the occurrence of cracking with respect to cooling/heating cycle resistance, and as a result, was confirmed to be good in workability in molding, have a high heat resistance and a high moisture resistance, and cause no cracking with respect to cooling/heating cycle resistance.

The present application is based on Japanese Patent Application (Japanese Patent Application No. 2012-140023) filed with JPO on June 21, 2012, and the content thereof is herein incorporated by reference.

## Claims

1. An epoxy resin obtained through the following steps (a) to (d):
(a): a step of reacting a compound represented by the following formula (1) and/or (2) with formaldehyde in the presence of a catalyst to thereby provide an aromatic hydrocarbon-formaldehyde resin;
(b): a step of treating the aromatic hydrocarbon-formaldehyde resin obtained in the step (a) with an acidic catalyst and water to thereby provide an acid-treated resin;
(c): a step of treating the acid-treated resin obtained in the step (b) with an acidic catalyst and a compound represented by the following formula (3) to thereby provide a modified resin; and
(d): a step of reacting the modified resin obtained in the step (c) with epihalohydrin to thereby provide an epoxy resin; 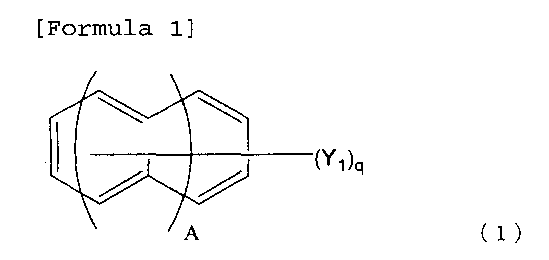 wherein Y₁ independently represents an alkyl group having 1 to 10 carbon atoms, an aryl group having 6 to 10 carbon atoms or a cyclohexyl group, q represents number of 0 to 3, and A represents number of 0 to 2; 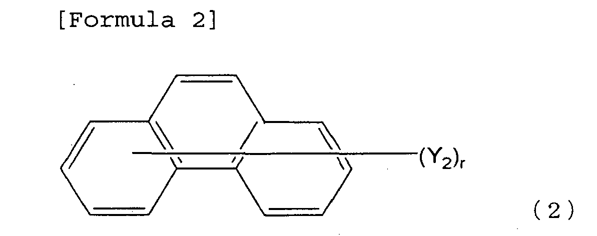 wherein Y₂ independently represents an alkyl group having 1 to 10 carbon atoms, an aryl group having 6 to 10 carbon atoms or a cyclohexyl group, and r represents number of 0 to 3; 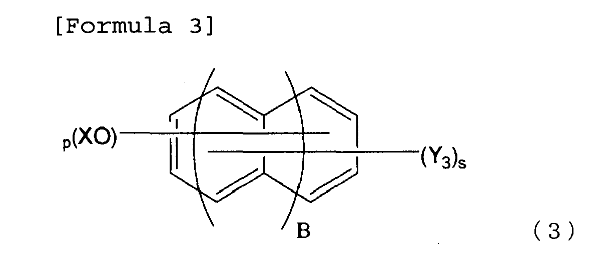 wherein X independently represents a hydrogen atom, an alkyl group having 1 to 10 carbon atoms, an aryl group having 6 to 10 carbon atoms or a cyclohexyl group, Y₃ independently represents an alkyl group having 1 to 10 carbon atoms, an aryl group having 6 to 10 carbon atoms or a cyclohexyl group, p represents number of 1 to 3, s represents number of 0 to 3, and B represents number of 0 to 3.

2. The epoxy resin according to claim 1, wherein the compound represented by the formula (1) is at least one selected from the group consisting of benzene, toluene, xylene, mesitylene, ethylbenzene, propylbenzene, decylbenzene, cyclohexylbenzene, biphenyl, methylbiphenyl, naphthalene, methylnaphthalene, dimethylnaphthalene, ethylnaphthalene, anthracene, methylanthracene, dimethylanthracene, ethylanthracene and binaphthyl.

3. The epoxy resin according to claim 1 or 2, wherein the compound represented by the formula (2) is at least one selected from the group consisting of phenanthrene, methylphenanthrene, dimethylphenanthrene, ethylphenanthrene, decylphenanthrene, cyclohexylphenanthrene, phenylphenanthrene and naphthylphenanthrene.

4. The epoxy resin according to any one of claims 1 to 3, wherein the compound represented by the formula (3) is at least one selected from the group consisting of phenol, methoxyphenol, benzoxyphenol, catechol, resorcinol, hydroquinone, cresol, phenylphenol, naphthol, methoxynaphthol, benzoxynaphthol, dihydroxynaphthalene, hydroxyanthracene, methoxyanthracene, benzoxyanthracene and dihydroxyanthracene.

5. The epoxy resin according to any one of claims 1 to 4, wherein, in the step (b), an amount of the acidic catalyst used is 0.0001 to 100 parts by mass based on 100 parts by mass of the aromatic hydrocarbon-formaldehyde resin, and an amount of the water used is 0.1 to 10000 parts by mass based on 100 parts by mass of the aromatic hydrocarbon-formaldehyde resin.

6. The epoxy resin according to any one of claims 1 to 5, wherein, in the step (c), an amount of the compound represented by the formula (3) used is 0.1 to 5 mol based on 1 mol of oxygen comprised in the acid-treated resin.

7. An epoxy resin composition comprising the epoxy resin according to any one of claims 1 to 6.

8. A cured product obtained by curing the epoxy resin composition according to claim 7.

9. A copper-clad laminate comprising the epoxy resin according to any one of claims 1 to 6.

10. A resin composition for a semiconductor sealing, comprising the epoxy resin according to any one of claims 1 to 6.

11. A method for producing an epoxy resin, comprising the following steps (a) to (d):
(a): a step of reacting a compound represented by the following formula (1) and/or (2) with formaldehyde in the presence of a catalyst to thereby provide an aromatic hydrocarbon-formaldehyde resin;
(b): a step of treating the aromatic hydrocarbon-formaldehyde resin obtained in step (a) with an acidic catalyst and water to thereby provide an acid-treated resin;
(c): a step of treating the acid-treated resin obtained in step (b) with an acidic catalyst and a compound represented by the following formula (3) to thereby provide a modified resin; and
(d): a step of reacting the modified resin obtained in step (c) with epihalohydrin to thereby provide an epoxy resin; 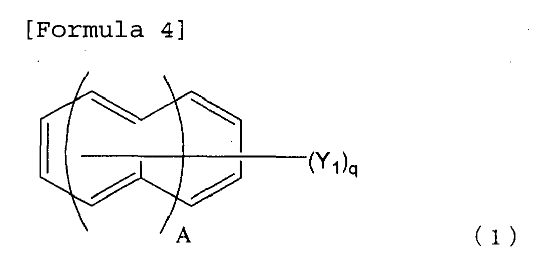 wherein Y₁ independently represents an alkyl group having 1 to 10 carbon atoms, an aryl group having 6 to 10 carbon atoms or a cyclohexyl group, q represents number of 0 to 3, and A represents number of 0 to 2; 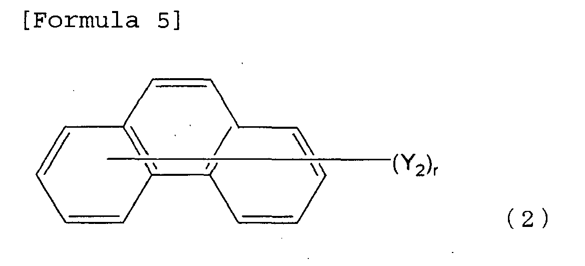 wherein Y₂ independently represents an alkyl group having 1 to 10 carbon atoms, an aryl group having 6 to 10 carbon atoms or a cyclohexyl group, and r represents number of 0 to 3; 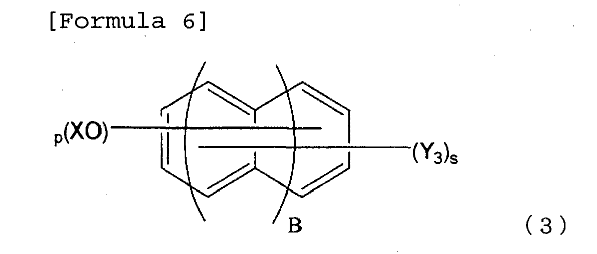 wherein X independently represents a hydrogen atom, an alkyl group having 1 to 10 carbon atoms, an aryl group having 6 to 10 carbon atoms or a cyclohexyl group, Y₃ independently represents an alkyl group having 1 to 10 carbon atoms, an aryl group having 6 to 10 carbon atoms or a cyclohexyl group, p represents number of 1 to 3, s represents number of 0 to 3, and B represents number of 0 to 3.
